# EUROPÄISCHE PATENTSCHRIFT

(11) **EP 1 564 250 B1**
(45) Veröffentlichungstag und Bekanntmachung des Hinweises auf die Patenterteilung: **21.04.2010**
(21) Anmeldenummer: 05001766.4
(22) Anmeldetag: 28.01.2005
(51) Int. Cl.: C08L 65/00, H01L 51/30

(54) **Polythiophenformulierungen zur Verbesserung von organischen Leuchtdioden**
Polythiophene compositions for improving organic light-emitting diodes
Compositions de polythiophènes pour améliorer les diodes électroluminescentes

(30) Priorität: 10.02.2004 DE 102004006583
(43) Veröffentlichungstag der Anmeldung: 17.08.2005
(73) Patentinhaber: H.C. Starck Clevios GmbH, 38642 Goslar (DE)
(72) Erfinder: Elschner, Andreas, Dr., 45479 Mühlheim (DE); Reuter, Knud, Dr., 47800 Krefeld (DE); Lövenich, Peter Wilfried, Dr., 51061 Köln (DE)
(74) Vertreter: Herzog, Martin

(56) Entgegenhaltungen:
- WO-A-02/42352
- US-A1- 2004 044 214

## Beschreibung

Die Erfindung betrifft Formulierungen enthaltend Polythiophene und weitere Polymere, deren Verwendung und elektrolumineszierende Anordnungen enthaltend lochinjizierende Schichten enthaltend diese Formulierungen.

Eine elektrolumineszierende Anordnung (EL-Anordnung) ist dadurch charakterisiert, dass sie bei Anlegung einer elektrischen Spannung unter Stromfluss Licht aussendet. Derartige Anordnungen sind unter der Bezeichnung "Leuchtdioden" (LEDs = "light emitting diodes") seit langem bekannt. Die Emission von Licht kommt dadurch zustande, dass positive Ladungen (Löcher, "holes") und negative Ladungen (Elektronen, "electrons") unter Aussendung von Licht rekombinieren.

Die in der Technik gebräuchlichen LEDs bestehen alle zum überwiegenden Teil aus anorganischen Halbleitermaterialien. Seit einigen Jahren sind jedoch EL-Anordnungen bekannt, deren wesentliche Bestandteile organische Materialien sind.

Diese organischen EL-Anordnungen enthalten in der Regel eine oder mehrere Schichten aus organischen Ladungstransportverbindungen.

Der prinzipielle Schichtaufbau einer EL-Anordnung ist wie folgt:
- 1: Träger, Substrat
- 2: Basiselektrode
- 3: Löcher-injizierende Schicht
- 4: Löcher-transportierende Schicht
- 5: Emitter-Schicht
- 6: Elektronen-transportierende Schicht
- 7: Elektronen-injizierende Schicht
- 8: Topelektrode
- 9: Kontakte
- 10: Umhüllung, Verkapselung

Dieser Aufbau stellt den detailliertesten Fall dar und kann vereinfacht werden, indem einzelne Schichten weggelassen werden, so dass eine Schicht mehrere Aufgaben übernimmt. Im einfachsten Fall besteht eine EL-Anordnung aus zwei Elektroden, zwischen denen sich eine organische Schicht befindet, die alle Funktionen - inklusive der der Emission von Licht - erfüllt.

Es hat sich aber in der Praxis gezeigt, dass zur Erhöhung der Leuchtdichte elektronen- und/oder lochinjizierende Schichten in den elektrolumineszierenden Aufbauten besonders vorteilhaft sind.

Aus der EP-A 686 662 ist bekannt, spezielle Mischungen aus leitfähigen organischen polymeren Leitern wie Poly(3,4-ethylendioxythiophen) und beispielsweise Polyhydroxyverbindungen oder Lactamen als Elektrode in Elektrolumineszenzanzeigen einzusetzen. Es hat sich aber in der Praxis gezeigt, dass diese Elektroden besonders für großflächige Anzeigen eine nicht ausreichende Leitfähigkeit aufweisen. Für kleine Anzeigen (Leuchtfläche < 1cm²) reicht die Leitfähigkeit dagegen aus. Die mögliche Verwendung von Dispersionen enthaltend speziell substituierte Poly(3,4-ethylendioxythiophene) und Polyanionen aufweisend mindestens eine Sulfonsäuregruppe, wie beispielsweise Polystyrolsulfonsäure, als transparente Elektrode in organischen oder anorganischen Elektrolumineszenzeigen, wird in der WO 02/42352 beschrieben. Allerdings werden hier keine konkreten Ausführungsbeispiele für diese Anwendung gezeigt.

Aus der DE-A 196 27 071 ist bekannt, polymere organische Leiter, z.B. Poly(3,4-ethylendioxythiophen), als lochinjizierende Schichten einzusetzen. Hierdurch kann die Leuchtstärke der elektrolumineszierenden Anzeigen gegenüber Aufbauten ohne den Einsatz polymerer organischer Zwischenschichten deutlich gesteigert werden. Durch Reduzierung der Teilchengröße der Poly(3,4-alkylendioxythiophen)-Dispersionen lässt sich die Leitfähigkeit gezielt einstellen. Damit gelingt es, ein elektrisches Übersprechen benachbarter Adresslinien (crosstalk) insbesondere in Passiv-Matrix-Anzeigen zu verhindern (EP-A 1 227 529). Die Lebensdauer dieser Anzeigen ist aber für viele praktische Anwendungen immer noch nicht ausreichend.

Es bestand daher weiterhin Bedarf, EL-Anordnungen herzustellen, die neben einer hohen Leuchtstärke (Leuchtintensität) eine höhere Lebensdauer, d.h. insbesondere eine höhere Betriebsdauer bei hoher Leuchtstärke, aufweisen als bekannte EL-Anordnungen.

Die Aufgabe der vorliegenden Erfindung bestand daher darin, geeignete Materialien zur Herstellung solcher EL-Anordnungen aufzufinden und bereitzustellen. Eine weitere Aufgabe bestand darin, aus diesen Materialien solche EL-Anordnungen herzustellen.

Überraschend wurde gefunden, das sich bisher unbekannte Formulierungen enthaltend speziell substituierte Polythiophene und in polaren Lösungsmitteln lösliche Polymere sich hervorragend zur Herstellung lochinjizierender Schichten für EL-Anordnungen eignen und die erhaltenen FL-Anordnungen deutlich höhere Lebensdauern aufweisen als bekannte EL-Anordnungen.

Gegenstand der vorliegenden Erfindung sind daher Formulierungen, d.h. Zusammensetzungen, enthaltend wenigstens ein Polythiophen enthaltend wiederkehrende Einheiten der allgemeinen Formel (I), 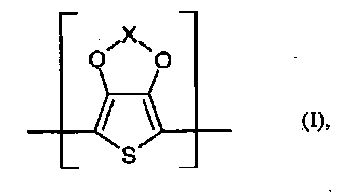 worin
- X für: -(CH₂)ₓ-CR¹R²-(CH₂)_{y}- steht, worin
R¹ für -(CH₂)ₛ-(CH₂)ₚ-R³ steht,
wobei
R³ für SO₃⁻M⁺ oder COO⁻M⁺ steht, wobei M⁺ für H¹, Li⁺, Na⁺, K⁺, Rb⁺, Cs⁺ oder NH₄⁺, bevorzugt für H⁺, Na⁺ oder K⁺, besonders bevorzugt für H⁺ steht,
s für eine ganze Zahl von 0 bis 10, bevorzugt 0 bis 3, besonders bevorzugt für 0 oder I steht und
p für eine ganze Zahl von 1 bis 18, bevorzugt 2 bis 6, besonders bevorzugt für 3, 4 oder 5 steht,
oder für (CH₂)_{q}-O(CH₂CH₂O)ᵣR⁴ steht,
wobei
R⁴ für gegebenenfalls substituiertes C₁-C₄-Alkyl steht,
q für eine ganze Zahl von 0 bis 10 steht und
r für eine ganze Zahl von 1 bis 12, bevorzugt für 2, 3 oder 4 steht,
R² unabhängig von R¹ für H, einen linearen oder verzweigten, gegebenenfalls substituierten C₁-C₂₀-Alkylrest, einen C₆-C₁₄-Arylrest oder für -(CH₂)ₛ-O-(CH₂)ₚ-R³ oder -(CH₂)_{q}-O(CH₂CH₂O)ᵣR⁴, bevorzugt für H,-steht,
wobei R³, s, p, R⁴, q und r die unter R¹ genannten Bedeutungen haben, und
x, y jeweils unabhängig voneinander für eine ganze Zahl von 0 bis 9, bevorzugt 0 bis 3, besonders bevorzugt für 0, 1 oder 2 stehen,
und wenigstens ein weiteres teilfluoriertes oder perfluoriertes SO₃⁻M⁺-Gruppen enthaltendes Polymer oder wenigstens ein weiteres teilfluoriertes oder perfluoriertes COO-M⁺-Gruppen enthaltendes Polymer, wobei M⁺ für H⁺, Li⁺, Na⁺, K⁺, Rb⁺, Cs⁺ oder NH₄⁺, bevorzugt für H⁺, Nₐ⁺ oder K⁺, besonders bevorzugt für H' steht.

Unter substituiert ist hier und im folgenden, wenn nicht ausdrücklich anders erwähnt, eine Substitution mit einer Gruppe ausgewählt aus der Reihe:
Alkyl, bevorzugt C₁-C₂₀-Alkyl-, Cycloalkyl-, bevorzugt C₃-C₂₀-Cycloalkyl-, Aryl-, bevorzugt C₅-C₁₄-Aryl-, Halogen-, bevorzugt Cl, Br, J, Ether-, Thioether-, Disulfid-, Sulfoxid-, Sulfon-, Amino-, Aldehyd-, Keto-, Carbonsäureester-, Cyano-, Alkylsilan- und Alkoxysilangruppen sowie Carboxylamidgruppen zu verstehen.

Die wiederkehrenden Einheiten der allgemeinen Formel (I) können innerhalb eines Polythiophens gleich oder verschieden sein. Bevorzugt sind es wiederkehrende Einheiten der allgemeinen Formel (I-a) und/oder (1-b), 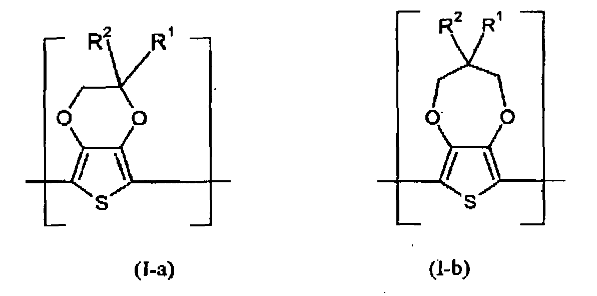 worin R¹ und R² die vorangehend für die allgemeine Formel (I) genannte Bedeutung haben.

Bevorzugte Ausführungsformen der vorliegenden Erfindung sind solche Formulierungen enthaltend wenigstens ein Polythiophen enthaltend wiederkehrende Einheiten der Formeln (I-a-1) und/oder (I-b-1) bzw. (I-a-2) und/oder (I-b-2)

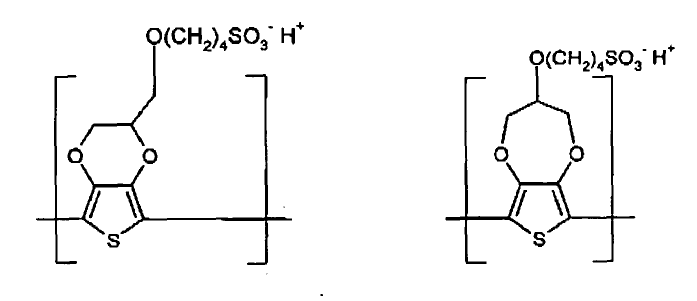

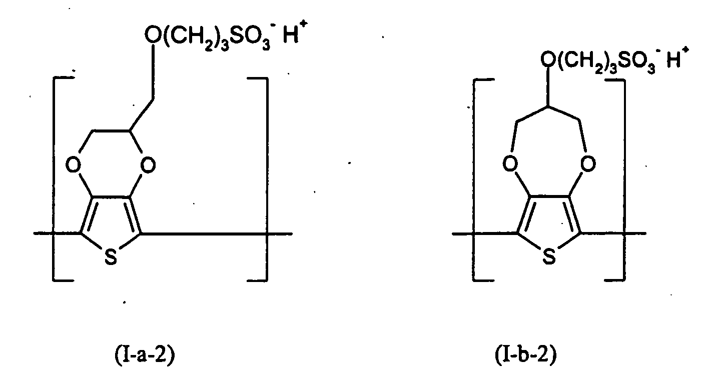

Für den Fall, dass wiederkehrende Einheiten der allgemeinen Formel (I-a) und/oder (I-b) bzw. (I-a-1) und/oder (I-b-1) bzw. (I-a-2) und/oder (I-b-2) im Polythiophen enthalten sind, können die Reste R¹ jeweils gleich oder verschieden und die Reste R² jeweils gleich oder verschieden, bevorzugt die Reste R¹ aber jeweils gleich und die Reste R² aber jeweils gleich sein.

Das Polythiophen kann sowohl aus wiederkehrenden Einheiten der allgemeinen Formel (I-a), (I-a-1) bzw. (I-a-2) oder aus wiederkehrenden Einheiten der allgemeinen Formel (I-b), (I-b-1) bzw. (I-b-2) als auch aus wiederkehrenden Einheiten der allgemeinen Formel (I-a) und (I-b), (I-a-1) und (I-b-1) bzw. (I-a-2) und (I-b-2) aufgebaut sein. Im letztgenannten Fall können die Einheiten der allgemeinen Formel (I-a) und (I-b), (I-a-1) und (I-b-1) bzw. (I-a-2) und (I-b-2) in beliebigen Anteilen im Polythiophen enthalten sein, bevorzugt sind die Einheiten der allgemeinen Formel (I-a), (I-a-1) bzw. (I-a-2) jedoch mit einem Anteil von 65 bis 99,5 %, besonders bevorzugt mit einem Anteil von 75 bis 99 %, ganz besonders bevorzugt mit einem Anteil von 75 bis 85 %, bezogen auf die Gesamtzahl der wiederkehrenden Einheiten im Polythiophen enthalten; die Einheiten der allgemeinen Formel (I-b), (I-b-1) bzw. (I-b-2) sind dann bevorzugt mit einem Anteil von 0,5 bis 35 %, besonders bevorzugt mit einem Anteil von 1 bis 25 %, ganz besonders bevorzugt mit einem Anteil von 15 bis 25 %, bezogen auf die Gesamtzahl der wiederkehrenden Einheiten im Polythiophen enthalten, mit der Maßgabe, dass die Summe beider Anteile 100 % ergibt.

Das Polythiophen kann aber auch neben den wiederkehrenden Einheiten der allgemeinen Formel (I), (I-a) und/oder (I-b), (I-a-1) und/oder (I-b-1) bzw. (I-a-2) und/oder (I-b-2) andere wiederkehrende Einheiten, beispielsweise wiederkehrende Einheiten der allgemeinen Formel (II) und/oder (III), enthalten, 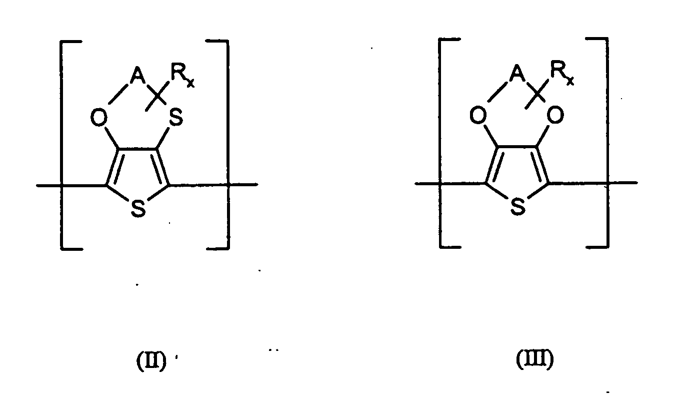 worin
- A: für einen gegebenenfalls substituierten C₁-C₅-Alkylenrest steht,
- R: für einen linearen oder verzweigten, gegebenenfalls substituierten C₁-C₈-Alkylrest, einen gegebenenfalls substituierten C₅-C₁₂-Cycloalkylrest, einen gegebenenfalls substituierten C₆-C₁₄-Arylrest, einen gegebenenfalls substituierten C₇-C₁₈-Aralkylrest, einen gegebenenfalls substituierten C₁-C₄-Hydroxyalkylrest oder einen Hydroxylrest steht,
- x: für eine ganze Zahl von 0 bis 8 steht und
für den Fall, dass mehrere Reste R an A gebunden sind, diese gleich oder unterschiedlich sein können.

Als gegebenenfalls weitere Substituenten der Reste R kommen zahlreiche organische Gruppen in Frage, beispielsweise Alkyl-, Cycloalkyl-, Aryl-, Halogen-, Ether-, Thioether-, Disulfid-, Sulfoxid-, Sulfon-, Amino-, Aldehyd-, Keto-, Carbonsäureester-, Cyano-, Alkylsilan- und Alkoxysilangruppen sowie Carboxylamidgruppen.

Das Polythiophen kann neben den wiederkehrenden Einheiten der allgemeinen Formel (I), (I-a) und/oder (I-b), (I-a-1) und/oder (I-b-1) bzw. (I-a-2) und/oder (I-b-2) bevorzugt wiederkehrende Einheiten der Formel (III-a) (3,4-Ethylendioxythiophen-Einheiten) enthalten

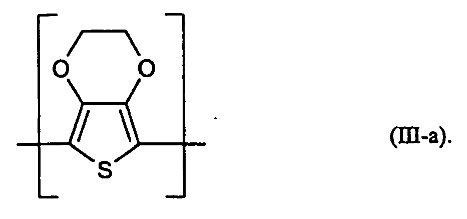

In bevorzugten Ausführungsformen der erfindungsgemäßen Formulierungen steht R² in den wiederkehrenden Einheiten der allgemeinen Formel (I), (I-a) und/oder (I-b) für H.

In weiteren bevorzugten Ausführungsformen der erfindungsgemäßen Formulierungen steht R³ in den wiederkehrenden Einheiten der allgemeinen Formel (I), (I-a) und/oder (I-b) für SO₃⁻M⁺, wobei M⁺ die vorangehend für die allgemeine Formel (I) genannte Bedeutung hat.

Für den Fall, dass es sich bei den Polythiophenen um Copolymere aus zwei oder mehreren sich voneinander unterscheidenden wiederkehrenden Einheiten der allgemeinen Formel (I) - hierunter sind hier und im Folgenden auch Einheiten der allgemeinen Formeln (I-a) und/oder (I-b) oder (I-a-1) und/oder (I-b-1) oder (I-a-2) und/oder (I-b-2) zu verstehen - oder wiederkehrenden Einheiten der allgemeinen Formel (I) und (II) und/oder (III) - hierunter sind hier und im Folgenden auch Einheiten der allgemeinen Formeln (III-a) zu verstehen - handelt, können die wiederkehrenden Einheiten statistisch, alternierend oder als Blöcke im Copolymeren enthalten sein.

Sowohl bei den Copolymeren enthaltend wiederkehrende Einheiten der allgemeinen Formel (I) und gegebenenfalls weitere wiederkehrende Einheiten der allgemeinen Formeln (II) und/oder (III) als auch bei den Homopolymeren enthaltend wiederkehrende Einheiten der allgemeinen Formel (I) kann die Verknüpfung der wiederkehrenden Einheiten regioregulär und/oder nicht regioregulär erfolgen.

Die wiederkehrenden Einheiten der allgemeinen Formeln (II) und/oder (III), bevorzugt der Formel (III-a), in einem Copolymeren aufweisend Struktureinheiten der Formeln (I) und (II) und/oder (III) sind in den Copolymeren bevorzugt zu einem Anteil von maximal 50 %, besonders bevorzugt von maximal 30 % - bezogen auf die Gesamtzahl der wiederkehrenden Einheiten im Copolymeren - enthalten. Die wiederkehrenden Einheiten der allgemeinen Formel (I) sind in solchen bevorzugten Copolymeren mit einem Anteil von mindestens 50 %, bevorzugt mit einem Anteil von mindestens 70 % - bezogen auf die Gesamtzahl der wiederkehrenden Einheiten im Copolymeren - enthalten. Dabei können wiederkehrende Einheiten der allgemeinen Formel (I-a) oder (I-b) oder (I-a) und (I-b) enthalten sein. Wiederkehrende Einheiten der allgemeinen Formel (I-a) und (I-b) können in beliebigen Mischungsverhältnissen enthalten sein. Bevorzugt sind wiederkehrende Einheiten der allgemeinen Formel (I-a) mit einem Anteil von 65 bis 100 %, besonders bevorzugt mit einem Anteil von 75 bis 99 %, ganz besonders bevorzugt mit einem Anteil von 75 bis 85 %, bezogen auf die Gesamtzahl der wiederkehrenden Einheiten der allgemeinen Formel (I) und die wiederkehrenden Einheiten der allgemeinen Formel (I-b) mit einem Anteil von 0 bis 35 %, besonders bevorzugt mit einem Anteil von 1 bis 25 %, ganz besonders bevorzugt mit einem Anteil von 15 bis 25 %, bezogen auf die Gesamtzahl der wiederkehrenden Einheiten der allgemeinen Formel (I) in den Copolymeren enthalten, mit der Maßgabe, dass die Summe beider Anteile 100 % ergibt.

An den Endgruppen tragen die Polythiophene bevorzugt jeweils H. Die Polythiophene enthalten insgesamt n wiederkehrende Einheiten der allgemeinen Formel (I) und gegebenenfalls der allgemeinen Formeln (U) und/oder (III), wobei n eine ganze Zahl von 2 bis 1000, bevorzugt 3 bis 100, besonders bevorzugt 4 bis 15 ist.

Unter wiederkehrenden Einheiten sind im Rahmen der Erfindung Einheiten der allgemeinen Formeln (I), (II) oder (III) zu verstehen, unabhängig davon, ob sie einmal oder mehrmals im Polythiophen enthalten sind. d.h. Einheiten der allgemeinen Formeln (I), (II) oder (III) sind auch dann als wiederkehrende Einheiten zu verstehen, wenn sie nur einmal im Polythiophen enthalten sind.

Erfindungsgemäße Formulierungen können auch solche sein, die neben wenigstens einem der vorangehend beschriebenen Polythiophene enthaltend wiederkehrende Einheiten der allgemeinen Formel (1) weitere leitfähige Polymere, wie beispielsweise Polyaniline oder Polypyrrole enthalten.

Die Herstellung der vorangehend beschriebenen Polythiophene enthaltend wiederkehrende Einheiten der allgemeinen Formel (I) ist prinzipiell in EP-A 1 122 274 oder US 5.111.327 beschrieben.

Die Polymerisation der entsprechenden monomeren Verbindungen wird gewöhnlich mit geeigneten Oxidationsmitteln in geeigneten Lösungsmitteln durchgeführt. Beispiele für geeignete Oxidationsmittel sind Eisen(III)-salze, insbesondere FeCl₃ und Eisen(III)-salze aromatischer und aliphatischer Sulfonsäuren, H₂O, K₂Cr₂O₇, K₂S₂O₈, Na₂S₂O₈, KMnO₄, Alkaliperborate und Alkali- oder Ammoniumpersulfate oder Mischungen dieser Oxidationsmittel. Weitere geeignete Oxidationsmittel sind beispielsweise in Handbook of Conducting Polymers (Ed. Skotheim, T.A.), Marcel Dekker: New York, 1986, Vol. 1, 46-57 beschrieben. Besonders bevorzugte Oxidationsmittel sind FcCl₃, Na₂S₂O₈ und K₂S₂O₈ oder Mischungen hiervon. Die Polymerisation wird bevorzugt bei einer Reaktionstemperatur von -20 bis 100°C durchgeführt. Besonders bevorzugt sind Reaktionstemperaturen von 20 bis 100°C. Gegebenenfalls wird die Reaktionslösung anschließend mit wenigstens einem Ionenaustauscher behandelt.

Geeignete Lösungsmittel sind z.B. polare Lösungsmittel wie beispielsweise Wasser, Alkohole wie Methanol, Ethanol, 2-Propanol, n-Propanol, n-Butanol, Diacetonalkohol, Ethylenglykol, Glycerin oder Mischungen aus diesen. Ebenfalls geeignet sind aliphatische Ketone wie Aceton und Methylethylketon, aliphatische Nitrile wie Acetonitril, aliphatische und cyclische Amide wie N,N-Dimethylacetamid, N,N-Dimethylformamid (DMF) und 1-Methyl-2-pyrrolidon (NMP), Ether wie Tetrahydrofuran (THF) sowie Sulfoxide wie Dimethylsulfoxid (DMSO) oder Mischungen aus diesen untereinander oder mit den vorangehend aufgeführten Lösungsmitteln.

Die entsprechenden monomeren Verbindungen zur Herstellung von Polythiophenen enthaltend wiederkehrende Einheiten der allgemeinen Formel (I) sind bekannt. Ihre Herstellung ist beispielsweise in Chevrot et al., J. Electroanal. Chem. 1998, 443, 217-226, Leclerc et al., Adv. Mater. 1997, 9, 1087-1094 und Reynolds et al., Polymer Preprints 1997, 38 (2), 320 beschrieben.

Die resultierenden Polythiophene sind sehr gut in den polaren Lösungsmitteln oder Lösungsmittelgemischen löslich.

Die erfindungsgemäßen Formulierungen enthalten wenigstens ein weiteres teilfluoriertes oder perfluoriertes SO₃⁻M⁺- oder wenigstens ein weiteres teilfluoriertes oderperfluoriertes COO⁻M⁺-Gruppen enthaltendes Polymer. Im Rahmen der Erfindung geeignete teilfluorierte oder perfluorierte SO⁻₃M⁺- oder COO⁻M⁺-Gruppen enthaltende Polymere sind bevorzugt solche, die keine vollständig konjugierte Hauptkette enthalten, im Folgenden auch kurz als nicht konjugiert bezeichnet werden. Bevorzugt sind diese Polymere in polaren Lösungsmitteln wie Wasser, Alkoholen wie Methanol, Ethanol, 2-Propanol, n-Propanol, n-Butanol, Diacetonalkohol, Ethylenglykol, Glycerin, aliphatischen Ketonen wie Aceton und Methylethylketon, aliphatischen Nitrilen wie Acetonitril, aliphatischen und cyclischen Amiden wie N,N-Dimethylacetamid, N,N-Dimethylformamid (DMF) und 1-Methyl-2-pyrrolidon (NMP), Ether wie Tetrahydrofuran (THF) sowie Sulfoxiden wie Dimethylsulfoxid (DMSO) oder Mischungen enthaltend diese, bevorzugt in Wasser, Alkoholen wie Methanol, Ethanol, 2-Propanol, n-Propanol und n-Butanol oder Mischungen aus diesen löslich.

Beispielhaft für geeignete teilfluorierte oder perfluorierte SO₃⁻M⁺- oder COO⁻M⁺-Gruppen enthaltende Polymere (Polysäure) seien kommerziell erhältlichePolymere genannt, die Sulfonsäuregruppen und CF₂-Gruppen enthalten, wie beispielsweise Nation^{®} (Copolymer aus Tetrafluorethylen und dem Trifluorvinylether des Poly(hexafluorpropylenoxid)mono-(tetrafluorvinylsulfonsäure)-ethers).

Solche teilfluorierten oder perfluorierte SO₃⁻M⁺- oder COO⁻M⁺-Gruppen enthaltende Polymere sind beispielsweise solche enthaltend wiederkehrende Einheiten der Formeln (IV-a) und (IV-b), 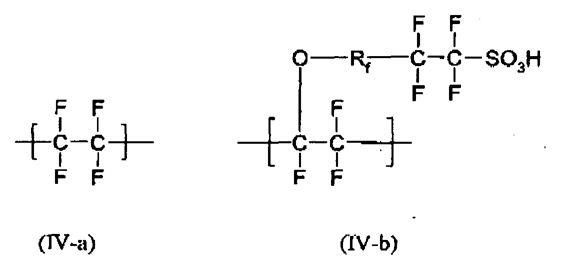 worin R_{f} für einen Rest mit wenigstens einer, bevorzugt 1 bis 30 wiederkehrenden Einheit(en) der Formel (IV-c) 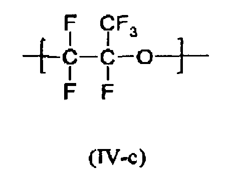 steht. Solche perfluorierten Polymere sind beispielsweise die kommerziell unter dem Handelsnamen Nafion^{®} oder in gelöster Form unter dem Handelsnamen Liquion^{®} erhältlichen Polymere.

In besonders bevorzugten Ausführungsformen enthält die erfindungsgemäße Formulierung als wenigstens ein teilfluoriertes oder perfluoriertes SO₃⁻M⁺- oder COO-M⁺-Gruppen enthaltendes Polymer Nafion^{®} (Copolymer aus Tetrafluorethylen und dem Trifluorvinylether des Poly(hexafluorpropylenoxid)mono(tetrafluorvinylsulfonsäure)-ethers).

In weiteren bevorzugten Ausführungsformen enthält die erfindungsgemäßeFormulierung wenigstens zwei teilfluorierte oder perfluorierte SO₃⁻M⁺- oder COO⁻M⁺-Gruppen enthaltende Polymere. In einer besonders bevorzugten Ausführungsform enthält die erfindungsgemäße Formulierung als teil- oder perfluorierte SO₃⁻M⁺- oder COO⁻M⁺-Gruppen enthaltendes Polymere Nafion^{®} und zusätzlich Polystyrolsulfonsäure (PSS) bzw. deren jeweilige Salze.

Das Molekulargewicht der Polysäuren beträgt vorzugsweise 1 000 bis 2 000 000, besonders bevorzeugt 2 000 bis 500 000. Die Polysäuren oder ihre Alkalisalze sind im Handel erhältlich, z.B. Polystyrolsulfonsäuren und-Polyacrylsäuren, oder aber nach bekannten Verfahren herstellbar (siehe z.B. Houben Weyl, Methoden der organischen Chemie, Bd. E 20 Makromolekulare Stoffe, Teil 2, (1987), S. 1141 u.f.).

Die erfindungsgemäßen Formulierungen enthalten bezogen auf einen Gewichtsteil Polythiophen(e) enthaltend wiederkehrende Einheiten der allgemeinen Formel (I) bevorzugt 1 bis 30 Gewichtsteile, besonders bevorzugt 2 bis 15 Gewichtsteile des oder der teilfluorierten oder perfluorierten SO₃⁻M⁺- oder COO⁻M⁺-Gruppen enthaltende(n) Polymer(e). Ganz besonders bevorzugt enthalten die erfindungsgemäßen Formulierungen das oder die Polythiophen(e) enthaltend wiederkehrende Einheiten der allgemeinen Formel (1) und das oder die SO₃⁻M⁺- oder COO⁻M⁺-Gruppen enthaltende(n) Polymer(e) in einem Gewichtsverhältnis von Polythiophen(en) zu SO₃⁻M⁺- oder COO⁻M⁺-Gruppen enthaltendem(n) Polymer(en) von 1 zu 2 (1:2) bis 1 zu 15 (1:15), insbesondere 1 zu 3 (1:3) bis 1 zu 15 (1:15).

Dieses Verhältnis von Polythiophen(en) zu teifluorierten oder perfluorierten SO₃⁻M⁺- oder COO⁻ M⁺-Gruppen enthaltendem(n) Polymer(en) kann direkt durch Mischung der beiden eingestellt werden.

Weiterhin können die erfindungsgemäßen Formulierungen insbesondere wenigstens ein polares Verdünnungsmittel enthalten. Unter polaren Verdünnungsmitteln sind im Rahmen der Erfindung Verdünnungsmittel mit einem Löslichkeitsparameter δ von 16 MPa^{1/2} und größer, bevorzugt 19 MPa^{1/2} und größer zu verstehen. Die Messung von Löslichkeitsparametern findet in der Regel bei Standardtemperatur (20°C) statt. Zur Messung und Berechnung von Löslichkeitsparametern siehe J. Brandrup et al., Polymer Handbook, 4th Ed., 1999, VII/675 - VII/688. Löslichkeitsparameter sind tabelliert, z.B. in J. Brandrup et al., Polymer Handbook, 4th Ed., 1999, VII/688 - VII/697. Bevorzugte polare Verdünnungsmittel sind Wasser, Alkohole wie Methanol, Ethanol, 2-Propanol, n-Propanol, n-Butanol, Diacetonalkohol, Ethylenglykol, Glycerin, aliphatische Ketone wie Aceton und Methylethylketon, aliphatische Nitrile wie Acetonitril, aliphatische und cyclische Amide wie N,N-Dimethylacctamid, N,N-Dimethylformamid (DMF) und 1-Methyl-2-pyrrolidon (NMP), Ether wie Tetrahydrofuran (THF) sowie Sulfoxide wie Dimethylsulfoxid (DMSO) oder Mischungen enthaltend diese. Besonders bevorzugte polare Lösungsmittel sind Wasser, Alkohole oder Mischungen enthaltend diese, ganz besonders bevorzugt sind Wasser, Methanol, Ethanol, n-Prupanol, 2-Propanol oder n-Butanol oder Mischungen enthaltend diese.

Solche neuen Formulierungen enthaltend wenigstens ein polares Verdünnungsmittel enthalten bevorzugt 99.99 bis 80 Gew.-%, besonders bevorzugt 99,8 bis 95 Gew.-% polare(s) Verdünnungsmittel und weisen einen Feststoffgehalt von 0,01 bis 20 Gew.-%, besonders bevorzugt 0,2 bis 5 Gew.-% auf, d.h. enthalten insgesamt 0,01 bis 20 Gew.-%, besonders bevorzugt 0,2 bis 5 Gew.-% Polythiophen(e), teilfluorierte oder perfluorierte SO₃⁻M⁺- oder COO⁻M⁺-Gruppen enthaltende(s) Polymer(e) und gegebenenfalls weitere enthaltene Komponenten, wie z.B. Bindemittel, Vernetzungsmittel und/oder Tenside, in gelöster und/oder dispergierter Form.

Die Viskosität bei 20°C von neuen Formulierungen enthaltend wenigstens ein polares Verdünnungsmittel liegt typischerweise zwischen der Viskosität des Verdünnungsmittels und 200 mPas, bevorzugt < 100 mPas.

Zur Einstellung des gewünschten Feststoffgehaltes und der erforderlichen Viskosität kann aus den Formulierungen die gewünschte Menge Verdünnungsmittel durch Destillation, bevorzugt im Vakuum, oder durch andere Verfahren, z.B. Ultrafiltration, entfernt werden.

Den erfindungsgemäßen Formulierungen können außerdem organische, polymere Bindemittel und/oder organische, niedermolekulare Vernetzungsmittel oder Tenside zugesetzt werden. Entsprechende Bindemittel sind z.B. in EP-A 564 911 beschrieben. Beispielhaft seien hier Polyvinylcarbazol, Silane, wie Silquest^{®} A187 (Fa. OSi specialities) oder Tenside, wie das Fluortensid FT 248 (Bayer AG, Tetraethylammoniumsalz der Perfluoroctylsulfonsäure) aufgeführt.

Die Formulierungen enthalten bevorzugt nur geringe Mengen ionischer Verunreinigungen in den Grenzen wie sie in EP-A 991 303 beschrieben sind. Bevorzugt enthalten die Formulierungen weniger als 1000 ppm ionischer Verunreinigungen.

Die erfindungsgemäßen Formulierungen können auf unterschiedliche Weise hergestellt werden. Beispielsweise ist es möglich, wenigstens ein Polythiophen mit wenigstens einem teilfluorierten oder perfluorierten SO₃⁻M⁺- oder COO⁻M⁺-Gruppen enthaltenden Polymer zu mischen und dieses Gemisch gegebenenfalls mit wenigstens einem Verdünnungsmittel zu versetzen, bevorzugt in wenigstens einem Verdünnungsmittel ganz oder teilweise zu lösen. Es ist auch möglich, wenigstens ein Polythiophen vorab in wenigstens einem Verdünnungsmittel zu lösen und wenigstens ein teilfluoriertes oder perfluoriertes SO₃⁻M⁺- oder COO⁻M⁺-Gruppen enthaltendes Polymer vorab in wenigstens einem Verdünnungsmittel zu lösen und die beiden Lösungen anschließend zu mischen. Gegebenenfalls kann aus dieser Mischung anschließend das oder die Verdünnungsmittel ganz oder teilweise wieder entfernt werden, z.B. durch Destillation oder andere Verfahren. Weiterhin besteht die Möglichkeit, die erfindungsgemäßen Formulierungen herzustellen, indem zunächst das oder die Polythiophen(e) durch Polymerisation der entsprechenden monomeren Verbindungen mit wenigstens einem geeigneten Oxidationsmittel in wenigstens einem geeigneten Lösungsmittel hergestellt wird (werden), wobei entweder das Lösungsmittel einem der vorangehend aufgeführten polaren Verdünnungsmittel entspricht oder nach abgeschlossener Polymerisation ein entsprechender Lösungsmittelaustausch bzw. Zusatz weiteren Lösungsmittels erfolgen kann. Zu dieser Lösung kann dann anschließend wenigstens ein teilfluoriertes oder perfluoriertes SO₃⁻M⁺- oder COO⁻M⁺-Gruppen enthaltendes Polymer - gegebenenfalls ebenfalls in wenigstens einem Verdünnungsmittel gelöst - mit der Polythiophenlösung gemischt werden. Gegebenenfalls kann auch aus dieser Mischung anschließend das oder die Verdünnungsmittel ganz oder teilweise wieder entfernt werden.

Überraschend eignen sich die erfindungsgemäßen Formulierungen hervorragend für die Herstellung lochinjizierender oder lochtransportierender Schichten in EL-Anordnungen, organischen Solarzellen, organischen Laserdioden, organischen Dünnfilmtransistoren oder organischen Feldeffekttransistoren, zur Herstellung von Elektroden oder elektrisch leitfähiger Beschichtungen.

Daher ist ebenfalls Gegenstand der vorliegenden Erfindung die Verwendung der erfindungsgemäßen Formulierungen zur Herstellung lochinjizierender Schichten in EL-Anordnungen, zur Herstellung von Elektroden oder elektrisch leitfähiger Beschichtungen.

Insbesondere EL-Anordnungen mit einer lochinjizierenden Schicht enthaltend eine erfindungsgemäße Formulierung zeichnen sich durch eine hohe Leuchtstärke (Leuchtintensität) und eine deutlich höhere Lebensdauer aus als bekannte EL-Anordnungen.

Ebenfalls Gegenstand der vorliegenden Erfindung sind daher EL-Anordnungen enthaltend eine lochinjizierende Schicht basierend auf einer erfindungsgemäße Formulierung. Bevorzugt sind dies solche EL-Anordnungen mindestens enthaltend wenigstens zwei Elektroden, wovon gegebenenfalls wenigstens eine auf ein gegebenenfalls transparentes Substrat aufgebracht ist, wenigstens eine Emitter-Schicht zwischen den beiden Elektroden und wenigstens eine lochinjizierenden Schicht zwischen einer der beiden Elektroden und der Emitter-Schicht aufgebracht ist, dadurch gekennzeichnet, dass die lochinjizierende Schicht eine erfindungsgemäße Formulierung enthält.

Bei der Herstellung von vielen großflächigen EL-Anordnungen, z.B. großflächigen elektrolumineszierenden Anzeigeelementen, ist es vorteilhaft, wenn mindestens eine der stromzuführenden Elektroden aus einem transparenten und leitfähigem Material besteht. Als solche transparenten und leitfähigen Elektroden-Materialien sind beispielsweise
a) Metalloxide, z.B. Indium-Zinn-Oxid (ITO), Zinnoxid (NESA), dotiertes Zinnoxid, dotiertes Zinkoxid etc.,
b) semi-transparente Metallfilme, z.B. Au, Pt, Ag, Cu etc.,
c) semi-transparente, leitfähige Polymere, z.B. Polythiophene, Polyaniline, Polypyrrole etc.
geeignet.

Bei einer Elektrode, die nicht aus einem der vorangehend aufgeführten transparenten und leitfähigen Materialien besteht, handelt es sich vorzugsweise um eine Metallelektrode, insbesondere um eine Metallkathode.

Geeignete Materialien für Metallkathoden sind die für elektrooptische Aufbauten gängigen und dem Fachmann bekannt. Als Metallkathode kommen bevorzugt solche aus Metallen mit geringer Austrittsarbeit wie Mg, Ca, Ba oder Metallsalzen wie LiF in Betracht.

Als gegebenenfalls transparentes Substrat eignen sich beispielsweise Glas, Dünnstglas (flexibles Glas) oder Kunststoffe, bevorzugt Kunststofffolien.

Besonders geeignete Kunststoffe sind: Polycarbonate, Polyester wie z.B. PET und PEN (Polyethylenterephthalat bzw. Polyethylennaphthalindicarboxylat), Copolycarbonate, Polyacrylat, Polysulfon, Polyethersulfon (PES), Polyimid, Polyethylen, Polypropylen oder cyclische Polyolefine bzw. cyclische Olefincopolymere (COC), hydrierte Styrolpolymere oder hydrierte Styrolcopolymere.

Geeignete Polymerunterlagen können beispielsweise Folien wie Polyesterfolien, PES-Folien der Firma Sumitomo oder Polycarbonalfolien der Firma Bayer AG (Makrofol^{®}) sein.

Zwischen dem Substrat und der Elektrode kann sich eine Haftvermittlerschicht befinden. Geeignete Haftvermittler sind beispielsweise Silane. Bevorzugt sind Epoxysilane, wie beispielsweise 3-Glycidoxypropyltrimethoxysilan (Silquest^{®} A187, Fa. OSi specialities). Es können auch andere Haftvermittler mit hydrophilen Oberflächeneigenschaften verwendet werden. So wird z.B. eine dünne Schicht aus PEDT:PSS als geeigneter Haftvermittler für PEDT beschrieben (Hohnholz et al., Chem. Commun. 2001, 2444-2445).

In der Emitter-Schicht der erfindungsgemäßen EL-Anordnung ist wenigstens ein Emittermaterial enthalten. Geeignete Emittermaterialien sind die für elektrooptische Aufbauten gängigen und dem Fachmann bekannt. Als Emittermaterialien kommen bevorzugt konjugierte Polymere wie Polyphenylenvinylene und/oder Polyfluorene, wie die beispielsweise in WO-A 90/13148 beschriebenen Polyparaphenylenvinylenderivate und Polyfluorenderivate, oder Emitter aus der Klasse der niedermolekularen Emitter, in Fachkreisen auch als "small molecules" bezeichnet, wie Aluminiumkomplexe, z.B. Tris(8-hydroxychinolinato)aluminium (Alq₃), Fluoreszenzfarbstoffe, z.B. Chinacridone, oder phosphoreszierende Emitter, z.B. Ir(ppy)₃, in Betracht. Emittermaterialien sind z.B. in DE-A 196 27 071 beschrieben.

Zusätzlich zu den vorangehend aufgeführten Schichten können weitere funktionelle Schichten in einem solchen elektrolumineszierenden Schichtaufbau (EL-Anordnung) enthalten sein, wie z.B. weitere ladungsinjizierende, z.B. elektroneninjizierende, ladungstransportierende oder ladungsblockierende Zwischenschichten. Solche Schichtaufbauten sind dem Fachmann bekannt und bcispielsweise in J.R. Sheats et al., Science 273, (1996), 884 beschrieben. Eine Schicht kann auch mehrere Aufgaben übernehmen. Beispielsweise können die vorangehend aufgeführten Emittermaterialien in Kombination mit einer lochtransportierenden Zwischenschicht zwischen lochinjizierender und Emitter-Schicht eingesetzt werden (vgl. z.B. US 4,539,507 und US 5,150,006).

Die prinzipielle Herstellung solcher EL-Anordnungen ist dem Fachmann bekannt. Sie können beispielsweise so hergestellt werden, dass eine Elektrode aus Lösung oder durch Aufdampfen auf ein Substrat aufgebracht wird. Z.B. werden Metalloxid- oder semi-transparente Metallfilmelektroden bevorzugt durch Aufdampfen, semi-transparente, leitfähige Polymerelektroden hingegen bevorzugt aus Lösung auf das Substrat aufgebracht. Gegebenenfalls kann vor Aufbringen des Elektrodenmaterials auf das Substrat ein Haftvermittler durch Aufdampfen oder aus Lösung - aufgebracht werden. Einige solcher mit Elektrodenmaterial beschichteten Substrate sind auch bereits kommerziell erhältlich (z.B. K-Glas, ITO beschichtete Glassubstrate). Auf die Elektrode kann anschließend die lochinjizierende Schicht aufgebracht werden, was bei den erfindungsgemäßen EL-Anordnungen mit lochinjizierender Schicht enthaltend eine erfindungsgemäße Formulierung vorteilhafterweise aus Lösung erfolgt. Auf die lochinjizierende Schicht werden anschließend die weiteren Schichten in der einleitend aufgeführten Reihenfolge - unter Berücksichtigung, dass einzelne Schichten weggelassen werden können - je nach eingesetztem Material aus Lösung oder durch Aufdampfen aufgebracht. Anschließend wird die Schichtanordnung kontaktiert und gekapselt.

Die Herstellung der lochinjizierenden Schicht enthaltend eine erfindungsgemäße Formulierung erfolgt nach bekannten Technologien. Dazu wird eine erfindungsgemäße Formulierung - gegebenenfalls in einem Lösungsmittel - auf einer Elektrode, bevorzugt der Basiselektrode, als Film aufgetragen. Als Lösungsmittel eignen sich die oben aufgeführten polaren Verdünnungsmittel, bevorzugt Wasser, Alkohole oder Mischungen aus diesen. Geeignete Alkohole sind z.B. Methanol, Ethanol, n-Propanol, 2-Propanol und n-Butanol.

Die Verwendung dieser Lösungsmittel hat den Vorteil, dass weitere Schichten aus organischen Lösungsmitteln, wie aromatischen oder aliphatischen Kohlenwvasserstoffgemischen aufgebracht werden können, ohne dass die lochinjizierende Schicht angegriffen wird.

Die erfindungsgemäße Formulierung - gegebenenfalls in einem Lösungsmittel - kann beispielsweise durch Techniken wie Spincoaten, Casting, Rakeln, Drucken, Vorhanggießen etc. auf der Elektrode gleichmäßig verteilt werden. Anschließend können die Schichten bei Raumtemperatur oder Temperaturen bis 300°C, bevorzugt 100 bis 200°C getrocknet werden.

Die erfindungsgemäße Formulierung - gegebenenfalls in einem Lösungsmittel - kann außerdem bevorzugt durch Techniken wie Ink-Jet strukturiert aufgebracht werden. Diese Technik ist dem Fachmann bekannt und unter Einsatz wasserlöslicher und dispergierter Polythiophene wie 3,4-Polyethylendioxythiophen:Polystyrolsulfonsäure (PEDT:PSS) z.B. in Science, Vol. 279, 1135, 1998 und DE-A 198 41 804 beschrieben.

Vorzugsweise werden die erfindungsgemäßen Formulierungen - gegebenenfalls in einem Lösungsmittel - vor der Applizierung durch ein Filter filtriert.

Besonders gut filtrierbare Formulierungen werden beispielsweise erhalten, wenn bezogen auf ein Gewichtsteil Polythiophen(e) enthaltend wiederkehrende Einheiten der allgemeinen Formel (I) bevorzugt 1 bis 30 Gewichtsteile, besonders bevorzugt 2 bis 15 Gewichtsteile des oder der reilfluorierten oder perfluorierten SO₃⁻M⁺- oder COO-M⁺-Gruppen enthallunde(n) Polymer(c) verwendet werden, ganz besonders bevorzugt die erfindungsgemäßen Formulierungen das oder die Polythiophen(e) enthaltend wiederkehrende Einheiten der allgemeinen Formel (I) und das oder die teilfluorierten oder perfluorierten SO₃⁻M⁺- oder COO⁻M⁺-Gruppen enthaltende(n) Polymer(e) in einem Gewichtsverhältnis von Polythiophen(en) zu teilfluorierten oder perfluorierten SO₃⁻M⁺- oder COO⁻M⁺-Gruppen enthaltendem(n) Polymer(en) von 1 zu 2 bis 1 zu 15 enthalten.

Die Dicke der lochinjizierenden Schicht beträgt beispielsweise 3 bis 500 nm, bevorzugt 10 bis 200 nm.

Die Einfluss einer lochinjizierenden Schicht enthaltend eine erfindungsgemäße Formulierung auf die Eigenschaften der EL-Anordnung kann in einem speziellen Aufbau einer solchen erfindungsgemäßen EL-Anordnung getestet werden. Dazu wird die lochinjizierende Schicht auf nasschemisch gereinigtes ITO-Substrat mittels Spin-Coater aufgebracht. Anschließend wird die Schicht bei 100-200°C für 5 min getrocknet. Die Schichtdicke beträgt je nach Rotationsgeschwindigkeit 20-300 nm. Als Emitter-Schicht wird eine 1 gew.-%ige Lösung eines polyfluorenbasierten Emittermaterials (Green 1300 LUMATION™ der Fa. Dow Chemical Company) in Xylol aufgeschleudert.

Die Dicke der Emitterschicht beträgt typischerweise 60-120 nm. Als Kathode wird abschließend eine 5 nm dicke Ba-Schicht und darauf eine 200 nm dicke Ag-Schicht aufgedampft. Durch Kontaktierung der Indiumzinnoxid(ITO)-Anode und der Metall-Kathode werden mittels eines Kennlinienschreibers und einer kalibrierten Photodiode Strom-Spannungs-Leuchtdichte-Kennlinien aufgenommen und Lebensdauern gemessen. Dazu wird durch die Anordnung ein konstanter elektrischer Strom oder ein Wechselstrom geschickt, und die Spannung und die Leuchtdichte werden zeitabhängig verfolgt.

Die erfindungsgemäßen organischen Leuchtdioden zeichnen sich durch hohe Lebensdauer, hohe Leuchtstärke, niedrige Einsatzspannungen und ein hohes Gleichrichtungsverhältnis aus. Im Vergleich zu bekannten Leuchtdioden mit lochinjizierenden Schichten hergestellt aus einer Poly(3,4-ethylendioxythiophen):Polystyrolsulfonsäure(PEDT:PSS)-Dispersion (Baytron^{®} P, H.C. Starck GmbH) wurde überraschend gefunden, dass die Lebensdauern erfindungsgemäßer organischer Leuchtdioden mit lochinjizierender Schicht enthaltend eine erfindungsgemäße Formulierung signifikant höher sind.

### Beispiel 1:

### Herstellung eines Polymers enthaltend 4-(2,3-dihydrothieno[3,4-b][1,4]dioxin-2-ylmethoxy)-1-butansulfonsäure)- und 4-(3,4-dihydro-2H-thieno[3,4-b][1,4]dioxepin-3-yl)-butansulfonsäure)-Wiederholungseinkeiten (PEDT-S)

17,5 g EDT-S (Gemisch aus 80 % 4-(2,3-dihydrothieno[3,4-b][1,4]dioxin-2-ylmethoxy)-1-butansulfonsäure und 20 % 4-(3,4-dihydro-2H-thieno[3,4-b][1,4]dioxepin-3-yl)-1-butansulfonsäure) als Natriumsalz wurden unter Stickstoftschutzgasatmosphäre (N₂) in 350 ml Wasser gelöst. Anschließend wurden 25,6 g FeCl₃ zugegeben. Die Lösung wurde danach 2 h bei Raumtemperatur (= RT, 23°C) gerührt, anschließend 12 h auf 100°C erhitzt und nach Abkühlung auf RT aufgearbeitet. Hierzu wurde die Lösung mit Wasser auf ca. 3 Gew.-% verdünnt und mit je 66 g Lewatit® S 100 (Kationenaustauscher der Bayer Chemicals AG) und Lewatit® MP 62 (Anionenaustauscher der Bayer Chemicals AG) durch 4 h Rühren bei 23 ° C entionisiert. Dieser Vorgang wurde noch dreimal wiederholt.
- Feststoffgehalt.: 1,45 Gew.-%
- Eisengehalt:: 1,7 ppm
- Natriumgehalt:: 32 ppm
- Sulfatgehalt:,: 15 ppm
- Chloridgehalt:: < 10 ppm

Das verwendete Natriumsalz des EDT-S wurde aus Baytron® M OH VP CH 8020 (Gemisch aus 80% 2,3-dihydrothieno[3,4-b][1,4]dioxin-2-yl-methanol und 20 % 3,4-dihydro-2H-thieno-[3,4-b][1,4]dioxepin-3-ol, H.C. Starck GmbH) in Analogie zu Chevrot et al., J. Electroanal. Chem. 1998, 443, S. 217 - 226 hergestellt. Nach ¹H-NMR-Analyse in D₂O besteht das Produkt aus 80 % 4-(2,3-dihydrothieno[3,4-b][1,4]dioxin-2-ylmethoxy)-1-butansulfonsäure und 20 % 4-(3,4-dihydro-2H-thieno[3,4-b][1,4]dioxepin-3-yl)-1-butansulfonsäure jeweils als Natriumsalz.

### Erfindungsgemäßes Beispiel 2.1:

20 g der entsprechend Beispiel 1 hergestellten PEDT-S-Lösung mit Feststoffgehalt von 1,45 Gew.-% werden mit 36,4 g einer 4,78 Gew.-% Lösung aus Nafion^{®} in einem Gemisch aus niederaliphatischen Alkoholen und Wasser (Nafion^{®} perfluorinated ion-exchange resin, 5 wt % solution in lower aliphatic alcohols/HH₂O", CAS-Nr. 66796-30-3, Aldrich-Best.-Nr. 27,470-4, nachgemessener Feststoffgehalt 4,78 Gew.-%) gemischt. Das Gewichts-Verhältnis von PEDT-S zu Nafion^{®} beträgt in dieser Lösung 1:6.

### Erfindungsgemäßes Beispiel 2.2:

20 g der entsprechend Beispiel 1 hergestellten PEDT-S-Lösung mit Feststoffgehalt von 1,45 Gew.-% werden mit 15,17 g einer 4,78 Gew.-% Lösung aus Nafion^{®} in einem Gemisch aus niederaliphatischen Alkoholen und Wasser (Nafion^{®} perfluorinated ion-exchange resin, 5 wt % solution in lower aliphatic alcohols/H₂O", CAS-Nr. 66796-30-3, Aldrich-Best.-Nr. 27,470-4, nachgemessener Feststoffgehalt 4,78 Gew.-%) gemischt. Das Gewichts-Verhältnis von PEDT-S zu Nafion^{®} beträgt in dieser Lösung 1:2,5.

### Vergleiehsbeispiel 2.3:

Die PEDT-S-Lösung aus Beispiel 1 wird mit unterschiedlichen Mengen einer Lösung aus Polystyrolsulfonsäure (PSS) in H₂O (HAPPS VP A1 4061, Feststoffgehalt 5,88 Gew.-%, H.C. Starck GmbH) gemischt.

| Gew.-Verhältnis PEDT-S : PSS | Zusammensetzung der Lösung für Schritt 2 |
|---|---|
| 1:1 | 2 1,1 g PHDT-S-Lösung mit 1,45 Gew.-% FG, |
| | 5,2 g PSS-Lösung mit 5,88 Gew.% FG, |
| 1:2,5 | 10,55 g PEDT-S-Lösung mit 1,45 Gew.-% FG, |
| | 6,37 g PSS-Lösung mit 5,88 Gew.-% FG |
| 1:6 | 10,55 g PEDT-S-Lösung mit 1,45 Gew.% FG, |
| | 15,61 g PSS-Lösung mit 5,88 Gew.-% FG |

### Erfindungsgemäßes Beispiel 3:

Die erfindungsgemäße Formulierung aus Beispiel 2.1 wird zum Aufbau einer organischen Leuchtdiode (OLED) genutzt. Bei der Herstellung der OLED wird folgendermaßen vorgegangen:

### 1. Reinigung des ITO-beschichteten Substrats

ITO-beschichtetes Glas (Mcrck Balzers AG, FL, Part. No. 253 674 XO) wird in 50 mm x 50 mmgroße Stücke (Substrate) geschnitten. Die Substrate werden anschließend in 3 %iger wässriger Mukasollösung im Ultraschallbad 15 min lang gereinigt. Danach werden die Substrate mit destilliertem Wasser gespült und in einer Zentrifuge trocken geschleudert. Dieser Spül- und Trockenvorgang wird 10 mal wiederholt. Unmittelbar vor der Beschichtung werden die ITO-beschichteten Seiten in einem UV/Ozon-Reaktor (PR-100, UVP Inc., Cambridge, GB) für 10 min gereinigt.

### 2. Aufbringen der lochinjizierenden Schicht

Etwa 10 ml der erfindungsgemäßen Mischung aus Beispiel 2.1 werden filtriert (Millipore HV, 0,45 µm). Das gereinigte ITO-beschichtete Substrat wird auf eine Lackschleuder gelegt und die filtrierte Lösung wird auf der ITO-beschichteten Seite des Substrats verteilt. Anschließend wird die überstehende Lösung durch Rotation des Tellers bei 1200 U/min über den Zeitraum von 30 s abgeschleudert. Danach wird das so beschichtete Substrat 5 min lang bei 200°C auf einer Heizplatte getrocknet. Die Schichtdicke beträgt 85 nm (Tencor, Alphastep 500).

### 3. Aufbringen der Emitterschicht

5 ml einer 1 Gew.-% Xylol-Lösung des Emitters Green 1300 LUMATION^{™} (Dow Chemical Company) werden filtriert (Millipore HV, 0,45 µm) und auf der getrockneten lochinjizierenden Schicht verteilt. Dieser und alle weiteren Prozessschritte werden in reiner N₂-Atmosphäre durchgeführt (Inertgas-Gloveboxsystem, M.Braun, Garching). Die Lochinjektionsschicht wird zuvor in der Glovebox nochmals für 5 min bei 200°C nachgetrocknet. Anschließend wird die überstehende Lösung des Emitters durch Rotation des Tellers bei 400 U/min 30 s lang abgeschleudert. Danach wird das so beschichtete Substrat 15 min lang bei 130°C auf einer Heizplatte getrocknet. Die Gesamtschichtdicke beträgt 185 nm.

### 4. Aufbringen der Metallkathode

Auf die Emitterschicht wird eine Metallelektrode gedampft. Das Substrat wird mit der Emitterschicht nach unten auf eine Lochmaske (Lochdurchmesser 2,5 mm) gelegt. Aus zwei Aufdampfschiffchen werden bei einem Druck von p = 10⁻³ Pa nacheinander eine 5 nm dicke Ba-Schicht und anschließend eine 200 nm dicke Ag-Schicht aufgedampft. Die Aufdampfraten betragen 10 Å/s für Ba und 20 Å/s für Ag.

### 5. Charakterisierung der OLED

Die beiden Elektroden der organischen LED werden über elektrische Zuführungen mit einer Spannungsquelle verbunden (kontaktiert). Der positive Pol ist mit der ITO-Elektrode, der negative Pol ist mit der Metall-Elektrode verbunden. Die Abhängigkeit des OLED-Stroms und der Elektrolumineszenzintensität (der Nachweis erfolgt mit einer Photodiode (EG&G C30809E) von der Spannung werden aufgezeichnet. Anschließend werden die Lebensdauern bestimmt, indem ein konstanter Strom von I=0.39 mA (8 mA/cm²) durch die Anordnung fließt, und die Spannung und Lichtintensität zeitabhängig verfolgt. Alle OLED-Charakterisierungen werden in der Glove-Box unter Inert-Bedingungen durchgeführt.

### Vergleichsbeispiel 3.1

### Herstellung einer OLED mit Polyethylendioxythiophen/Polystyrolsulfonsäure als lochinjizierender Schicht:

Die Durchführung erfolgt wie in Beispiel 3, mit folgender Abweichung bei Prozessschritt 2.:

### 2. Aufbringen der Lochinjektions-Schicht

Etwa 10 ml einer 1,3 %igen Polyethylendioxythiophen/Polystyrolsulfonsäure-Lösung (Baytron^{®} P, TP AI 4083; Hersteller H.C. Starck GmbH), die zuvor noch durch Säulenchromatographie entsalzt wurde, werden filtriert (Millipore HV, 0,45 µm). Das ITO-beschichtete Substrat wird anschließend auf eine Lackschleuder gelegt und die filtrierte Lösung wird auf der ITO-beschichteten Seite des Substrats verteilt. Anschließend wird die überstehende Lösung durch Rotation des Tellers bei 1500 U/min über den Zeitraum von 30 s abgeschleudert. Danach wird das so beschichtete Substrat 5 min lang bei 200°C auf einer Heizplatte getrocknet. Die Schichtdicke beträgt 85 nm.

Das Aufbringen der Metallkathoden gemäß Prozessschritt 4 erfolgte gemeinsam mit den Schichtaufbauten aus Beispiel 3, um Vergleichbarkeit zu gewährleisten.

Ergebnisse der Charakterisierung der OLED's aus Beispiel 3 und Vergleichsbeispiel 3.1:

| | t = 0 | | t = 800h | |
|---|---|---|---|---|
| | U/[V] | L/[rel.Einh.] | U/[V] | L/[rel.Einh.] |
| OLED aus Beispiel 3 | 3,57 | 1,83 | 4,25 | 1,63 |
| OLED aus Vergleichsbeispiel 3.1 | 3,67 | 1,74 | 4,46 | 0,59 |

Verglichen werden Spannung U und Leuchtintensität L, gemessen als Photodiodenstrom, zu Beginn des Lebensdauertests (t = 0) mit den entsprechenden Werten nach 800 Std. (t = 800 h) Dauerbelastung bei I = 8 mA/cm²

Der Vergleich der beiden OLED's zeigt, dass die erfindungsgemäße OLED aus Beispiel 3 mit der lochinjizierenden Schicht enthaltend die erfindungsgemäße Formulierung eine deutlich längere Lebensdauer im Betrieb aufweist als die OLED aus Vergleichsbeispiel 3.1 mit der lochinjizierenden Schicht aus bekanntem Material (PEDT:PSS).

### Erfindungsgemäßes Beispiel 4:

Die erfindungsgemaße Formulierung aus Beispiel 2.1 wird zum Aufbau einer organischen Leuchtdiode (OLED) genutzt. Bei der Herstellung der OLED wird wie im Beispiel 3 vorgegangen, mit folgender Abweichung in den Prozessschritten 1.,4. und 5.:

Anstelle von ganzflächig beschichteten ITO-Substraten (vgl. Beispiel 3, Prozessschritt 1.) werden strukturierte ITO-Substrate verwendet. Die ITO-Strukturen bestehen aus voneinander isolierten Streifen mit einer Breite von 2,0 mm. Die Strukturierung des ITO wurde mit üblicher Photoresisttechnik und anschließendem Abätzen in FeCl₃-Lösung vorgenommen.

Anstatt durch eine Lochmaske (vgl. Beispiel 3, Prozessschritt 4) wird die Metallkathode durch eine Streifenmaske, die senkrecht zu den ITO-Streifen orientiert wird, aufgedampft. Die Breite der Streifen beträgt 2 mm. Die aktive Leuchtfläche am Kreuzungspunkt der beiden Elektroden beträgt 4 mm².

Anstelle eines konstanten Stroms und Betrieb bei Gleichstrom (DC-Betrieb) (vgl. Beispiel 3, Prozessschritt 5) wird bei den Lebensdauermessungen eine spezielle Wechselspannung an die Anordnungen angelegt. Die Frequenz der Wechselspannung beträgt 100 Hz. Während der positiven Halbwclle fließt ein konstanter Strom von 640 µA, während der negativen Halbwelle liegt eine Spannung von -10 V an. Das Taktverhältnis von positiver zu negativer Halbwelle beträgt 50:50. Die integrale Flächenstromdichte beträgt 8 mA/cm²

### Vergleichsbeispiel 4.1

### Herstellung einer OLED mit Polyethylendioxythiophen/Polystyrolsulfonsäure als lochinjizierender Schicht:

Die Durchführung erfolgt wie im Beispiel 4, mit folgender Abweichung bei Prozessschritt 2.:

### 2. Aufbringen der Lochinjektions-Schicht

Etwa 10 ml einer 1,3 %igen Polyethylendioxythiophen/Polysulfonsäure-Lösung (Baytron^{®} P, TP AI 4083, Gewichtsverhältnis PEDT:PSS von 1:6; Hersteller H.C. Starck GmbH) werden filtriert (Millipore HV, 0,45 µm). Das ITO-beschichtete Substrat wird anschließend auf eine Lackschleuder gelegt und die filtrierte Lösung wird auf der ITO-beschichteten Seite des Substrats verteilt. Anschließend wird die überstehende Lösung durch Rotation des Tellers bei 1500 U/min über den Zeitraum von 30 sec abgeschleudert. Danach wird das so beschichtete Substrat 5 min lang bei 200°C auf einer Heizplatte getrocknet. Die Schichtdicke beträgt 85 nm.

### Vergleichsbeispiel 4.2

### Herstellung einer OLED mit Polyethylendioxythiophen/Polystyrolsulfonsäure als lochinjizierender Schicht:

Die Durchführung erfolgt wie im Vergleichsbeispiel 4.1, mit folgender Abweichung bei Prozessschritt 2.:

### 2. Aufbringen der Lochinjektions-Schicht

Etwa 10 ml einer 1,3 %igen Polyethylendioxythiophen/Polysulfonsäure-Lösung (Baytron^{®} P, TP AI 4083, Gewichtsverhältnis PEDT:PSS von 1:6; Hersteller H.C. Starck GmbH), die zuvor noch durch Säulenchromatographie entsalzt wird, wird filtriert (Millipore HV, 0,45 µm). Das ITO-beschichtete Substrat wird anschließend auf eine Lackschleuder gelegt und die filtrierte Lösung wird auf der ITO-beschichteten Seite des Substrats verteilt. Anschließend wird die überstehende Lösung durch Rotation des Tellers bei 1500 U/min über den Zeitraum von 30 s abgeschleudert. Danach wird das so beschichtete Substrat 5 min lang bei 200°C auf einer Heizplatte getrocknet. Die Schichtdicke beträgt 85 nm.

Das Aufbringen der Metallkathoden - gemäß Prozessschritt 4 - der Schichtaufbauten aus Beispiel 4, Vergleichsbeispiel 4.1 und 4.2 erfolgte in einem gemeinsamen Prozessschritt, um Vergleichbarkeit zu gewährleisten.

Ergebnisse der Charakterisierung der OLED's aus Beispiel 4 und Vergleichsbeispielen 4.1 und 4.2:

| | t=0 | | t = 800 h | |
|---|---|---|---|---|
| | U/[V] *) | L/[rel.Einh.] | U/[V] *) | L/[rel.Einh.] |
| OLED aus Beispiel 4 | 4,12 | 2,07 | 4,25 | 1,88 |
| OLED aus Vergleichsbeispiel 4.1 | 4,11 | 1,45 | 4,74 | 0,36 |
| OLED aus Vergleichsbeispiel 4.2 | 4,24 | 1,55 | 4,84 | 0,45 |

| | | | | |
|---|---|---|---|---|
| *) gemessen während der positiven Halbwelle | | | | |

Auch bei gepulster elektrischer Ansteuerung erweist sich die erfindungsgemäße EL-Anordnung mit der lochinjizierenden Schicht enthaltend die erfindungsgemäße Formulierung (OLED aus Beispiel 4) als effizienter und zeigt eine deutlich höhere Lebensdauer als die EL-Anordnungen mit der lochinjizierenden Schicht aus bekanntem Material PEDT:PSS (OLEDs aus Vergleichsbeispielen 4.1 und 4.2).

Damit ist gezeigt, dass die Verwendung einer erfindungsgemäßen Formulierung als lochinjizierende Schicht im erfindungsgemäßen OLED zu deutlich längerer Lebensdauer der OLED im Betrieb gegenüber OLEDs führt, die lochinjizierende Schichten aus bekannten Materialien (PEDT:PSS) enthalten.

### Erfindungsgemäßes Beispiel 5.1:

Die erfindungsgemäße Formulierung aus Beispiel 2.1 wird zum Aufbau einer organischen Leuchtdiode (OLED) genutzt. Bei der Herstellung der OLED wird wie im Beispiel 3 vorgegangen.

### Erfindungsgemäßes Beispiel 5.2:

Die erfindungsgemäße Formulierung aus Beispiel 2.2 wird zum Aufbau einer organischen Leuchtdiode (OLED) genutzt. Bei der Herstellung der OLED wird wie im Beispiel 5.1 vorgegangen, mit der Abweichung, dass bei Prozessschritt 2 die erfindungsgemäße Formulierung aus Beispiel 2.2 verwendet wird.

### Vergleichsbeispiel 5.3:

### Herstellung einer OLED mit Polyethylendioxythiophen/Polystyrolsulfonsäre (PEDT:PSS) als lochinjizierender Schicht:

Die Durchführung erfolgt wie im Beispiel 5.1, mit folgender Abweichung bei Prozessschritt 2.:

### 2. Aufbringen der Lochinjektion-Schicht

Etwa 10 ml einer 2,8 %igen Polyethylendioxythiophen/Polysulfonsäure-Lösung (Baytron^{®} P, TP CH8000, Gewichtsverhältnis PEDT:PSS 1:20; Hersteller H.C. Starck GmbH) werden filtriert (Millipore HV, 0,45 µm). Das ITO-beschichtete Substrat wird anschließend auf eine Lackschleuder gelegt und die filtrierte Lösung wird auf der ITO-beschichteten Seite des Substrats verteilt. Anschließend wird die überstehende Lösung durch Rotation des Tellers bei 1000 U/min über den Zeitraum von 30 sec abgeschleudert. Danach wird das so beschichtete Substrat 5 min lang bei 200°C auf einer Heizplatte getrocknet. Die Schichtdicke beträgt 80 nm.

Das Aufbringen der Metallkathoden - gemäß Prozessschritt 4 - der Schichtaufbauten aus Beispiel 5.1, Beispiel 5.2 und Vergleichsbeispiel 5.3 erfolgte in einem gemeinsamen Prozessschritt, um Vergleichbarkeit zu gewährleisten.

Ergebnisse der Charakterisierung der OLED's aus den Beispielen 5.1 und 5.2 sowie dem Vergleichsbeispiel 5.3.:

| | t=0 | | t=500h | |
|---|---|---|---|---|
| | U/[V] | L/[rel.Einh.] | U/[V] | L/[rel.Einh.] |
| OLED aus Beispiel 5.1 | 3,49 | 1,57 | 4,20 | 1,41 |
| OLED aus Beispiel 5.2 | 3,58 | 1,72 | 4,59 | 1,19 |
| OLED aus Vergleichsbeispiel 5.3 | 3,68 | 1,68 | 4,82 | 0,54 |

Verglichen werden Spannung U und Leuchtintensität L, gemessen als Photodiodenstrom, zu Beginn des Lebensdauertests (t = 0) mit den entsprechenden Werten nach 500 Std. (t = 500 h) Dauerbelastung bei I = 8 mA/cm².

Die beiden erfindungsgemäßen OLEDs aus den Beispielen 5.1 und 5.2 weisen höhere Lebensdauern auf als die OLED aus Vergleichsbeispiel 5.3 mit dem bekannten Material PEDT:PSS in der lochinjizierenden Schicht. Zudem wird gezeigt, dass die Verwendung der erfindungsgemäßen Formulierung aus Beispiel 2.1 (Gewichts-Verhältnis von PEDT-S zu Nafion^{®} von 1:6) zur Herstellung einer lochinjizierenden Schicht zu noch längeren Lebensdauern der resultierenden erfindungsgemäßen EL-Anordnung im Betrieb führt als bei Verwendung der erfindungsgemäßen Formulierung aus Beispiel 2.2 (Gewichts-Verhältnis von PEDT-S zu Nafion^{®} von 1:2,5).

### Vergleicchsbeispiel 6

Die Formulierungen aus Beispiel 2.3 werden zum Aufbau organischer Leuchtdioden (OLED) genutzt. Bei der Herstellung der OLEDs wird wie im Beispiel 3 vorgegangen; mit folgender Abweichung in den Prozessschritten 1., 2. und 4.:

Anstelle von ganzflächig beschichteten ITO-Substraten (vgl. Beispiel 3, Prozessschritt 1.) werden strukturierte ITO-Substrate verwendet. Die ITO-Strukturen bestehen aus voneinander isolierten Streifen mit einer Breite von 2.0 mm. Die Strukturierung des ITO wurde mit üblicher Photoresisttechnik und anschließendem Abätzen in FeCl₃-Lösung vorgenommen.

Anstelle der Lösung aus Beispiel 2.1 werden in Prozessschritt 2, Beispiel 3 jeweils die Lösungen aus Beispiel 2.3 eingesetzt.

Anstatt durch eine Lochmaske (vgl. Beispiel 3, Prozessschritt 4) wird die Metallkathode durch eine Streifenmaske, die senkrecht zu den ITO-Streifen orientiert wird, aufgedampft. Die Breite der Streifen beträgt 1 mm. Die aktive Leuchtfläche am Kreuzungspunkt der beiden Elektroden beträgt 2 mm².

### Vergleichsbeispiel 6.1:

Die Lösung aus Beispiel 1 ohne Zusatz eines weiteren Polymers wird zum Aufbau organischer Leuchtdioden (OLED) genutzt. Dazu wird der Feststoffgehalt der Lösung aus Beispiel 1 durch Einengen am Rotationsverdampfer auf 5,12 Gew.-% erhöht (PEDT-S-Lösung). Bei der Herstellung der OLEDs wird wie im Beispiel 6 vorgegangen, mit der Abweichung, dass in Prozessschritt 2 die PEDT-S-Lösung eingesetzt wird.

Ergebnisse der Charakterisierung der OLED's aus Vergleichsbeispiel 6 und Vergleichsbeispiel 6.1.:

| Gew.-Verhältnis PEDT-S:PSS | Zusammensetzung der Lösung für Prozessschritt 2 | U - 8V | |
|---|---|---|---|
| | | I [mA/cm²] | L [rel.Einh.] |
| nur PEDT-S | PEDT-S-Lösung mit Feststoffgehalt (FG) 5,12 % | 900 | 4,3 10⁻⁶ |
| 1:1 | 21,1 g PEDT-S-Lösung mit 1,45 % FG, | 900 | 8,0-10-⁶ |
| | 5,2 g PSS-Lösung mit 5,88 % FG, | | |
| 1:2,5 | 10,55 g PEDT-S-Lösung mit 1,45 % FG, | 1000 | 5,0-10-⁵ |
| | 6,37 g PSS-Lösung mit 5,88 % FG | | |
| 1:6 | 10.55 g PEDT-S-Lösung mit 1,45 % FG, | 900 | 5,1-10⁻⁵ |
| | 15,61g PSS-Lösung mit 5,88 % FG | | |

Verglichen werden Flächenstrom I und Leuchtintensität L der Anordnungen bei U = 8 V.

Der Vergleich der OLEDs aus Vergleichsbeispiel 6 und Vergleichsbeispiel 6.1 zeigt, dass eine OLED mit einer lochinjizierenden Schicht aus reinem PEDT-S niedrigere Leuchtdichten bei vergleichbarem Flächenstrom und damit niedrigere Effizienz aufweist als OLEDs mit einer lochinjizierenden Schicht hergestellt aus den Formulierungen aus Beispiel 2.3. Zudem zeigt der Vergleich, dass sich die Effizienz durch Erhöhen des Gewichtsverhältnisses von PEDT-S:PSS von 1:1 auf 1:2,5 bzw. 1:6 deutlich steigern lässt.

## Patentansprüche

1. Formulierung enthaltend wenigstens ein Polythiophen enthaltend wiederkehrende Einhcitcn der allgemeinen Formel (I), 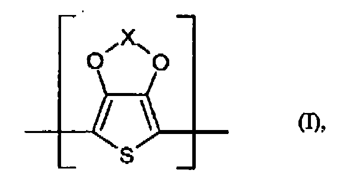 worin
X für-(CH₂)ₓ-CR¹R²-(CH₂)_{y}-steht, worin
R¹ für (CH₂)ₛ-O-(CH₂)ₚ-R³,
wobei
R³ für SO₃⁻M⁺ oder COO⁻M⁺ steht, wobei M⁺ für H⁺, Li⁺, Na⁺, K⁺, Rb⁺, Cs⁺ oder NH₄⁺ steht,
s für eine ganze Zahl von 0 bis 10 steht und
p für eine ganze Zahl von 1 bis 18 steht,
oder für -(CH₂)_{q}-O(CH₂CH₂O)ᵣR⁴ steht,
wobei
R⁴ für gegebenenfalls substituiertes C₁-C₄-Alkyl steht,
q für eine ganze Zahl von 0 bis 10 steht und
r für eine ganze Zahl von 1 bis 12 steht,
R² unabhängig von R¹ für H, einen gegebenenfalls substituierten C₁-C₂₀-Alkylrest, einen C₆-C₁₄-Arylrest oder für -(CH₂)ₓ-O-(CH₂)ₚ-R³ oder -(CH₂)_{q}-O(CH₂CH₂O)ᵣR⁴ steht,
wobei R³, s, p, R⁴, q und r die unter R¹ genannten Bedeutungen haben,
und
x, y jeweils unabhängig voneinander für eine ganze Zahl von 0 bis 9 stehen,
und wenigstens ein weiteres teilfluoriertes oder perfluoriertes SO₃⁻M⁺-Gruppen enthaltendes Polymer oder wenigstens ein weiteres teilfluoriertes oder perfluorierte COO⁻ M⁺-Gruppen enthaltendes Polymer, wobei M⁺ für H⁺, Li⁺, Na⁺, K⁺, Rb⁺, Cs⁺ oder NH₄⁺ steht.

2. Formulierung gemäß Anspruch 1, **dadurch gekennzeichnet, dass**
M⁺ unabhängig voneinander für H⁺, Na⁺ oder K⁺ steht,
s für eine ganze Zahl von 0 bis 3 steht,
p für eine ganze Zahl von 2 bis 6 steht, und
x, y jeweils unabhängig voneinander für eine ganze Zahl von 0 bis 3 stehen.

3. Formulierung gemäß Anspruch 1 oder 2, **dadurch gekennzeichnet, dass**
M⁺ für H⁺ steht,
s für 0 oder 1 steht,
p für 3, 4 oder 5 steht, und
x, y jeweils unabhängig voneinander für 0, 1 oder 2 stehen.

4. Formulierung gemäß wenigstens einem der Ansprüche 1 bis 3, **dadurch gekennzeichnet, dass** R² für H steht.

5. Formulierung gemäß wenigstens einem der Ansprüche 1 bis 4, **dadurch gekennzeichnet, dass** sie als wenigstens ein teilfluoriertes oder perfluoriertes SO₃⁻M⁺- Gruppen enthaltendes Polymer Nafion^{®} (Copolymer aus Tetrafluorethylen und dem Trifluorvinylether des Poly(hexafluorpropylenoxid)mono(tetrafluorvinylsulfonsäure)-ethers) oder dessen Salz enthält.

6. Formulierung gemäß wenigstens einem der Ansprüche 1 bis 5, **dadurch gekennzeichnet, dass** sie wenigstens zwei teilfluorierte oder perfluorierte COO⁻M⁺-oder SO3⁻M⁺-Gruppen enthaltende Polymere enthält.

7. Formulierung gemäß wenigstens einem der Ansprüche 1 bis 4, **dadurch gekennzeichnet, dass** sie als teil- oder perfluoriertes SO₃⁻M⁺- Gruppen enthaltendes Polymere Nafion^{®} und zusätzlich Polystyrolsulfonsäure (PSS) enthält.

8. Formulierung gemäß wenigstens einem der Ansprüche 1 bis 7, **dadurch gekennzeichnet, dass** sie das oder die Polythiophen(e) enthaltend wiederkehrende Einheiten der allgemeinen Formel (I) und das oder die teilfluorierte oder perfluorierte SO₃⁻M⁺- oder COO⁻ M⁺-Gruppen enthaltande(n) Polymer(e) in einem Gewichtsverhältnis von Polythiophen(en) zu SO₃⁻M⁺- oder COO⁻M⁺-Gruppen enthaitendem(n) Polymer(en) von 1 zu 2 bis 1 zu 15 enthält.

9. Formulierung gemäß wenigstens einem der Ansprüche 1 bis 8, **dadurch gekennzeichnet, dass** sie wenigstens ein polares Verdünnungsmittel enthält.

10. Formulierung gemäß Anspruch 9, **dadurch gekennzeichnet, dass** als polares Verdünnungsmittel Wasser, Alkohole oder Mischungen enthaltend Wasser und Alkohole verwendet werden.

11. Formulierung gemäß Anspruch 9 oder 10, **dadurch gekennzeichnet, dass** als polares Verdünnungsmittel Wasser, Methanol, Ethanol, n-Propanol, 2-Propanol oder n-Butanol oder Mischungen enthaltend diese verwendet werden.

12. Verwendung der Formulierung gemäß wenigstens einem der Ansprüche 1 bis 11 zur Herstellung lochinjizierender oder lochtransportierender Schichten in EL-Anordnungen, organischen Solarzellen, organischen Laserdioden, organischen Dünnfilmtransistoren oder organischen Feldeffekttransistoren, zur Herstellung von Elektroden oder elektrisch leitfähiger Beschichtungen.

13. EL-Anordnung mindestens enthaltend wenigstens zwei Elektroden, wovon gegebenenfalls wenigstens eine auf ein gegebenenfalls transparentes Substrat aufgebracht ist, wenigstens eine Emitter-Schicht zwischen den beiden Elektroden und wenigstens eine lochinjizierende Schicht zwischen einer der beiden Elektroden und der Emitter-Schicht aufgebracht ist, **dadurch gekennzeichnet, dass** die lochinjizierende Schicht eine Formulierung gemäß wenigstens einem der Ansprüche 1 bis 11 aufweist.

14. Organische Leuchtdiode enthaltend eine EL-Anordnung nach Anspruch 13.

## Claims

1. Formulation comprising at least one polythiophene comprising repeating units of the general formula (I) 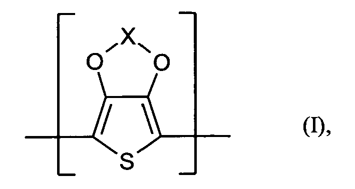 wherein
X represents -(CH₂)ₓ-CR¹R²-(CH₂)_{y} wherein
R¹ represents -(CH₂)ₛ-O-(CH₂)ₚ-R³,
wherein
R³ represents SO₃⁻M⁺ or COO⁻M⁺, wherein M⁺ represents H⁺, Li⁺, Na⁺, K⁺, Rb⁺, Cs⁺ or NH₄⁺,
s represents an integer from 0 to 10 and
p represents an integer from 1 to 18,
or represents -(CH₂)_{q}-O(CH₂CH₂O)ᵣR⁴,
wherein
R⁴ represents optionally substituted C₁-C₄-alkyl,
q represents an integer from 0 to 10 and
r represents an integer from 1 to 12,
R² independently of R¹ represents H, an optionally substituted C₁-C₂₀-alkyl radical, a C₆-C₁₄-aryl radical or -(CH₂)ₛ-O-(CH₂)ₚ-R³ or -(CH₂)_{q}-O(CH₂CH₂O)ᵣR⁴,
wherein R³, s, p, R⁴, q and r have the meanings given under R¹,
and
x, y each independently of each other represent an integer from 0 to 9,
and at least one further partly fluorinated or perfluorinated polymer comprising SO₃⁻M⁺ groups or at least one further partly fluorinated or perfluorinated polymer comprising COO-M⁺ groups, wherein M⁺ represents H⁺, Li⁺, Na⁺, K⁺, Rb⁺, Cs⁺ or NH₄⁺.

2. Formulation according to claim 1, **characterized in that**
M⁺ independently of each other represents H⁺, Na⁺ or K⁺,
s represents an integer from 0 to 3,
p represents an integer from 2 to 6 and
x, y each independently of each other represent an integer from 0 to 3.

3. Formulation according to claim 1 or 2, **characterized in that**
M⁺ represents H⁺,
s represents 0 or 1,
p represents 3, 4 or 5, and
x, y each independently of each other represent 0, 1 or 2.

4. Formulation according to at least one of claims 1 to 3, **characterized in that** R² represents H.

5. Formulation according to at least one of claims 1 to 4, **characterized in that** it comprises Nafion^{®} (copolymer of tetrafluoroethylene and the trifluorovinyl ether of poly(hexafluoropropylene oxide) mono(tetrafluorovinylsulphonic acid) ether) or a salt thereof as at least one partly fluorinated or perfluorinated polymer comprising SO₃⁻M⁺ groups.

6. Formulation according to at least one of claims 1 to 5, **characterized in that** it comprises at least two partly fluorinated or perfluorinated polymers comprising COO⁻M⁺ or SO₃⁻M⁺ groups.

7. Formulation according to at least one of claims 1 to 4, **characterized in that** it comprises Nafion^{®} as the partly fluorinated or perfluorinated polymer containing SO₃⁻M⁺ groups and additionally polystyrenesulphonic acid (PSS).

8. Formulation according to at least one of claims 1 to 7, **characterized in that** it comprises the polythiophene(s) comprising repeating units of the general formula (I) and the partly fluorinated or perfluorinated polymer(s) comprising SO₃-M⁺ or COO⁻M⁺ groups in a weight ratio of polythiophene(s) to polymer(s) comprising SO₃⁻M⁺ or COO⁻M⁺ groups of from 1:2 to 1:15.

9. Formulation according to at least one of claims 1 to 8, **characterized in that** it comprises at least one polar diluent.

10. Formulation according to claim 9, **characterized in that** water, alcohols or mixtures comprising water and alcohols are used as the polar diluent.

11. Formulation according to claim 9 or 10, **characterized in that** water, methanol, ethanol, n-propanol, 2-propanol or n-butanol or mixtures comprising these are used as the polar diluent.

12. Use of the formulation according to at least one of claims 1 to 11 for the production of hole-injecting or hole-transporting layers in EL arrangements, organic solar cells, organic laser diodes, organic thin film transistors or organic field effect transistors, for the production of electrodes or electrically conductive coatings.

13. EL arrangement at least comprising at least two electrodes, optionally at least one of which is applied to an optionally transparent substrate, at least one emitter layer applied between the two electrodes and at least one hole-injecting layer applied between one of the two electrodes and the emitter layer, **characterized in that** the hole-injecting layer comprises a formulation according to at least one of claims 1 to 11.

14. Organic light-emitting diode comprising an EL arrangement according to claim 13.

## Revendications

1. Formulation comprenant au moins un polythiophène comprenant des unités répétitives de la formule générale (I) 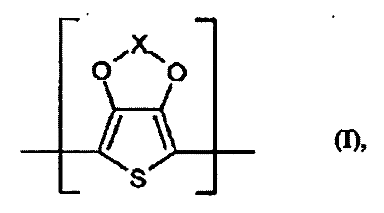 dans laquelle
X représente -(CH₂)ₓ-CR¹R²-(CH₂)_{y}-, où
R¹ représente -(CH₂)ₛ-O-(CH₂)ₚ-R³
sachant que
R³ représente So₃-M⁺ ou COO-M⁺, M⁺ représentant H⁺, Li⁺,
Na⁺, K⁺, Rb⁺, Cs⁺ ou NH₄⁺,
s représente un nombre entier de 0 à 10 et
p représente un nombre entier de 1 à 18
ou représente -(CH₂)_{q}-O(CH₂CH₂O)ᵣR⁴,
sachant que
R⁴ représente un alkyle en C₁ à C₄, substitué le cas échéant,
q représente un nombre entier de 0 à 10 et
r représente un nombre entier de 1 à 12,
R² représente, indépendamment de R¹, H, un radical alkyle en C₁ à C₂₀, substitué le cas échéant, un radical aryle en C₆ à C₁₄, ou -(CH₂)ₛ-O-(CH₂)ₚ-R³ ou -(CH₂)_{q}-O(CH₂CH_{2O})ᵣR⁴, sachant que R³, s, p, R⁴, q et r ont les significations données pour R¹
et
x et y représentent chacun, indépendamment l'un de l'autre, un nombre entier de 0 à 9,
et au moins un autre polymère partiellement fluoré ou perfluoré comprenant des groupes SO₃⁻M⁺ ou au moins un autre polymère partiellement fluoré ou perfluoré comprenant des groupes COO⁻M⁺, M⁺ représentant H⁺, Li⁺, Na⁺, K⁺, Rb⁺, Cs⁺ ou NH₄⁺.

2. Formulation selon la revendication 1, **caractérisée en ce que**
M⁺ représente indépendamment l'un de l'autre H⁺, Na⁺ ou K⁺,
s représente un nombre entier de 0 à 3,
p représente un nombre entier de 2 à 6, et
x, y représentent chacun, indépendamment l'un de l'autre, un nombre entier de 0 à 3.

3. Formulation selon la revendication 1 ou 2, **caractérisée en ce que**
M⁺ représente H⁺,
s représente 0 ou 1,
p représente 3, 4 ou 5, et
x, y représentent chacun, indépendamment l'un de l'autre, 0, 1 ou 2.

4. Formulation selon l'une au moins des revendications 1 à 3, **caractérisée en ce que** R² représente un H.

5. Formulation selon l'une au moins des revendications 1 à 4, **caractérisée en ce qu'**elle comprend en tant qu'au moins un polymère partiellement fluoré ou perfluoré comprenant des groupes SO₃⁻M⁺ du Nafion^{®} (copolymère de tétrafluoréthylène et de l'éther trifluorovinylique du poly(oxyde d'hexafluoropropylène)mono(acide tétrafluorovinylsulfonique)éther) ou son sel.

6. Formulation selon l'une au moins des revendications 1 à 5, **caractérisée en ce qu'**elle comprend au moins deux polymères partiellement fluorés ou perfluorés comprenant des groupes COO⁻M⁺ ou SO₃⁻M⁺.

7. Formulation selon l'une au moins des revendications 1 à 4, **caractérisée en ce qu'**elle contient en tant que polymères partiellement fluorés ou perfluorés contenant des groupes COO⁻M⁺ ou SO₃⁻M⁺ du Nafion® et en plus de l'acide poly(styrène sulfonique) (PSS).

8. Formulation selon l'une au moins des revendications 1 à 7, **caractérisée en ce qu'**elle comprend le ou les polythiophènes comprenant des unités répétitives de la formule générale (I) et le ou les polymères partiellement fluorés ou perfluorés comprenant des groupes SO₃⁻M⁺ ou COO⁻M⁺ dans un rapport pondéral des polythiophènes aux polymères comprenant des groupes SO₃⁻M⁺ ou COO⁻M⁺ compris entre 1 : 2 et 1 : 15.

9. Formulation selon l'une au moins des revendications 1 à 8, **caractérisée en ce qu'**elle comprend au moins un diluant polaire.

10. Formulation selon la revendication 9, **caractérisée en ce que** comme diluant polaire, on utilise de l'eau, des alcools ou des mélanges comprenant de l'eau et des alcools.

11. Formulation selon la revendication 9 ou 10, **caractérisée en ce que** comme diluant polaire, on utilise de l'eau, du méthanol, de l'éthanol, du n-propanol, du 2-propanol ou du n-butanol, ou des mélanges comprenant ces derniers.

12. Utilisation de la formulation selon l'une au moins des revendications 1 à 11 à la fabrication de couches injectant ou transportant des trous dans des dispositifs à EL, dans des cellules photovoltaïques organiques, dans des diodes laser organiques, dans des transistors organiques à film mince ou dans des transistors organiques à effet de champ, à la fabrication d'électrodes ou de revêtements conducteurs de l'électricité.

13. Dispositif à EL au moins comprenant deux électrodes ou plus, dont le cas échéant l'une ou plus est appliquée sur un substrat, transparent le cas échéant, une couche émettrice ou plus étant placée entre les deux électrodes et une couche ou plus injectant des trous étant placée entre l'une des deux électrodes et la couche émettrice, **caractérisé en ce que** la couche injectant des trous présente une formulation selon l'une au moins des revendications 1 à 11.

14. Diode électroluminescente organique comprenant un dispositif à EL selon la revendication 13.
